(19) Europäisches Patentamt
European Patent Office
Office européen des brevets

(11) **EP 1 873 916 A2**

(12) **EUROPÄISCHE PATENTANMELDUNG**

(43) Veröffentlichungstag:
**02.01.2008 Patentblatt 2008/01**

(51) Int Cl.:
**H03K 17/0814** (2006.01)  **H03K 17/785** (2006.01)
**H03K 17/0416** (2006.01)

(21) Anmeldenummer: **07011809.6**

(22) Anmeldetag: **15.06.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **29.06.2006 DE 102006030448**

(71) Anmelder: **Phoenix Contact GmbH & Co. KG
32825 Blomberg (DE)**

(72) Erfinder:
• **Oster, Viktor
32825 Blomberg (DE)**
• **Landwehr, Heinz-Carsten
32657 Lemgo (DE)**

(74) Vertreter: **Kampfenkel, Klaus
Blumbach - Zinngrebe
Patentanwälte
Alexandrastrasse 5
65187 Wiesbaden (DE)**

(54) **Sichere Ausgangschaltung mit einem einkanaligen Perpherieanschluss für den Ausgang eines Bus-Teilnehmers**

(57)     Die Erfindung betrifft eine Ausgangsschaltung für eine Ausgangsbaugruppe zum Schalten wenigstens einer angeschlossenen Last. Aufgabe der Erfindung ist es eine Schaltung zum ausgangsseitigen Schalten wenigstens einer angeschlossenen Last aufzuzeigen, insbesondere eine Schaltung, welche auch den Standards DIN EN 954-1 oder IEC 61508 genügt.

Die Erfindung schlägt eine Ausgangsschaltung für eine Ausgangsbaugruppe zum Schalten wenigstens einer angeschlossenen Last, insbesondere induktiven Last, vor, welche sich durch einen einkanaligen Peripherieanschluss (PA) zum Anschließen der wenigstens einen Last auszeichnet, und wenigstens zwei zwischen einer Versorgungsspannung und dem Peripherieanschluss in Reihe geschaltete Treibermodule (101; 102), insbesondere FET-Transistoren, umfasst, wobei jedes der Treibermodule über einen separaten Steuerkanal (OUT_LK1, IC10; OUT_LK2, IC20) mit einer der Ausgangsbaugruppe zugeordneten Logik zur Ansteuerung der Treibermodule verbunden ist.

Fig. 1

**Beschreibung**

Beschreibung

Die Erfindung betrifft eine Ausgangsschaltung für eine Ausgangsbaugruppe, insbesondere Bus-Ausgangsbaugruppe, zum Schalten wenigstens einer angeschlossenen Last.

Zum Ausgeben von sicherheitsrelevanten Signalen an Aktoren oder Lasten, wie beispielsweise Schützen, Motoren, Relais u.s.w. werden insbesondere in der Sicherheitstechnik hohe Anforderungen an die Fehlererkennung und das Ausfallverhalten der Schaltung sowie der Peripherie gestellt, die beispielsweise auch den Standards DIN EN 954-1 oder IEC 61508 genügen müssen. Zum Erfüllen dieser Anforderungen sind bisher üblicherweise komplexe zweikanalige Strukturen der Ausgangsschaltung erforderlich, was einen erhöhten Aufwand in der Schaltungsrealisierung und in der Beschaltung der Peripherie bedeutet, d.h. insbesondere auch in Bezug auf die Verdrahtung zum Aktor. Derartige Schaltungen sind somit sehr komplex aufgebaut und folglich auch kostenintensiv. Durch den erhöhten Bedarf an Bauelementen sind die Schaltungen zu dem noch meist relativ schlecht in der Verfügbarkeit.

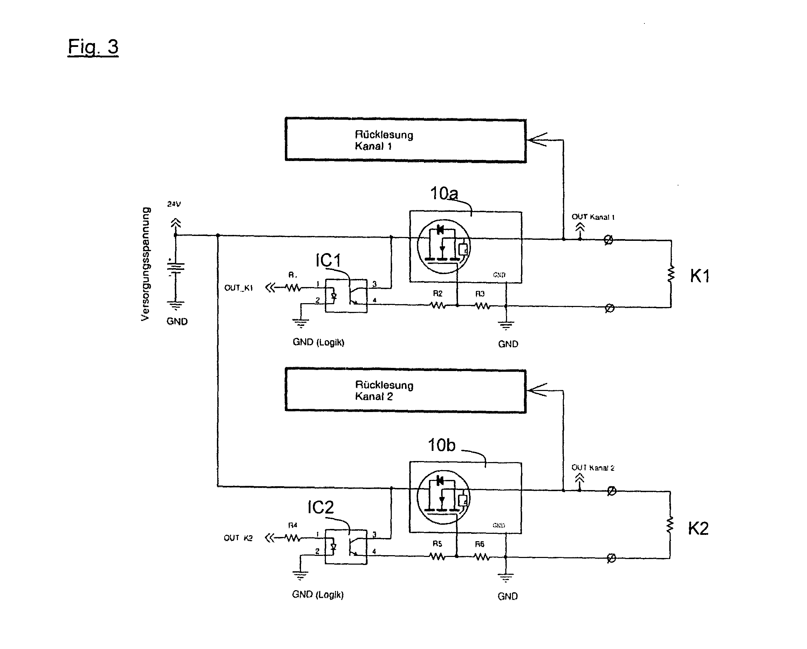

Fig. 3 zeigt eine Schaltung nach dem Stand der Technik zur Ansteuerung und Beschaltung von zweikanaligen Aktoren. Gemäß Schaltung nach Fig. 3 ist jeweils ein Ausgangstreiberbaustein 10a und 10b zur Ansteuerung jeweils eines Lastkanals K1 bzw. K2 vorgesehen. Folglich sind beim Testen der Schaltung stets auch hierfür eingesetzte Testimpulse am Ausgang sichtbar bzw. vorhanden, da andernfalls der einwandfreie Betrieb eines jeden Treiberbausteins 10a oder 10b nicht zu testen ist. Derartige, am Ausgang sichtbare Testimpulse können jedoch eine angeschaltete Last stören. Dies gilt beispielsweise auch, wenn die Testimpulse nur recht kurz gehalten sind, da beispielsweise auch bei schnell laufenden Maschinen, bei denen zum Beispiel ein Linear-Motor zum Einsatz kommt, nur wenige Millisekunden erforderlich sind, um deren Endgeschwindigkeit zu erreichen. Eine derartige Schaltung nach dem Stand der Technik ist daher für diverse elektronische Lasten nur bedingt bis gar nicht einsetzbar.

Weitere Nachteile sind, dass zur Realisierung folglich auch eine erhöhte Anzahl von Bauteilen benötigt wird, welches wiederum einen erhöhten Platzbedarf nach sich zieht. So ist z.B. zum Testen eines jeden Treiberbausteins 10a und 10b jeweils eine Rückleseschaltung erforderlich. Da ferner für redundant anzuschaltende Lasten eine erhöhte Anzahl von Schnittstellen oder Klemmstellen zur Peripherie bereitgestellt werden muss, ist auch eine erhöhte Anzahl von Schutzelementen erforderlich. Wird eine solche oder ähnliche Schaltung zum Schalten von induktiven Lasten verwendet, ergeben sich darüber hinaus Probleme des Zusammenwirkens zwischen induktiven Lasten und den in der Ausgangsschaltung eingesetzten Treiberbausteinen.

Da die in induktiven Lasten gespeicherte Energie beim Abschalten der Treiberbausteine herkömmlicherweise zu einer induktiven Schaltenergie führt, welche die Überlastung des Treiberbausteins zur Folge haben kann und diesen folglich auch zerstören kann, schreiben Hersteller üblicherweise eine externe Schutzbeschaltung vor, in welcher die in der Last abgespeicherte Energie umgesetzt werden soll. Andernfalls würde beispielsweise im Falle eines überlasteten Ausgangstreiberbausteins, dessen interne Temperaturüberwachung bei Überhitzung anspricht, der Treiberbaustein abgeschaltet und das Abschalten würde dazu führen, dass die induktive Abschaltenergie der Last zusätzlich in dem Treiber umgesetzt wird, welches zur Zerstörung des Treibers führt. Die vorgegebenen Schutzbeschaltungen sollen die hierbei auftretenden negativen Abschaltspannungen auf einen Wert begrenzen, bei dem der Treiberbaustein nicht mehr belastet bzw. lediglich innerhalb unkritischer Grenzen belastet wird.

Aufgabe der Erfindung ist es somit eine neue und gegenüber dem Stand der Technik wesentlich verbesserte Schaltung zum ausgangsseitigen Schalten wenigstens einer angeschlossenen Last aufzuzeigen, insbesondere eine Schaltung, welche auch den Standards DIN EN 954-1 oder IEC 61508 genügt.

Eine erfindungsgemäße Lösung der Aufgabe ist durch den Gegenstand mit dem Merkmal des Anspruchs 1 gegeben.

Vorteilhafte und/oder bevorzugte Ausgestaltungen, Verwendungen, Weiterbildungen und die erfindungsgemäße Schaltung umfassende Baugruppen sind Gegenstand der weiteren Ansprüche.

Die Erfindung schlägt somit bei einer Ausgangsschaltung für eine Ausgangsbaugruppe, insbesondere eine Bus-Ausgangsbaugruppe, zum Schalten wenigstens einer angeschlossenen Last, insbesondere induktiven Last, vor, diese mit einem einkanaligen Peripherieanschluss zum Anschließen der wenigstens einen Last und wenigstens zwei zwischen einer Versorgungsspannung und dem Peripherieanschluss in Reihe geschalteten Treibermodulen, insbesondere FET-Transistoren, auszubilden, wobei jedes der Treibermodule über einen separaten Steuerkanal mit einer der Ausgangsbaugruppe zugeordneten Logik zur Ansteuerung der Treibermodule verbunden ist.

Ein wesentlicher Vorteil hierdurch ist, dass aufgrund der Reihenschaltung der Treibermodule diese im Normalbetrieb immer gleichzeitig geschaltet werden können und in Folge der aufsummierten Reverse-Spannungen der wenigstens zwei Treibermodule im Falle des Anschaltens einer induktiven Last eine induktive Abschaltenergie auf den negativen Wert der Versorgungsspannung begrenzt werden kann.

Ein weiterer Vorteil besteht darin, dass der einkanalig aufgebaute Peripherieanschluss aufgrund der durch die wenigstens zwei Ausgangstreiber bereitgestellten Abschaltwege auch das Anschalten von wenigstens zweikanaligen oder von redundanten Lasten ermöglicht. Durch die hierdurch beim Abschalten der Last bewirkte erhöhte Sicherheit ist die erfindungsgemäße Schaltung insbesondere beim Einsatz in der Sicherheitstechnik besonders vorteilhaft.

Ein weiterer Vorteil besteht darin, dass aufgrund der getrennten Ansteuerwege für das Ein- und Ausschalten von jedem Treibermodul, ein gegebenenfalls auftretender Fehler in einem Baustein sich nicht zwangsläufig auf beide Abschaltwege auswirkt.

Jedem der Treibermodule kann somit über den einen gemeinsamen Peripherieanschluss ein Lastkanal zugewiesen werden, so dass die Schaltung auch zum Aufbau von zwei oder mehr Kanälen verwendbar ist, wobei auch die insbesondere in der Sicherheitstechnik vorgegebenen Anforderungen an zwei- und mehrkanalige Systeme nach DIN EN 954-1 erfüllt werden.

Ein weiterer Vorteil besteht darin, dass applikationsspezifisch eine Mehrzahl von unterschiedlichen Testzyklen zum Prüfen jedes der in Reihe geschalteten Treibermodule durchlaufen werden kann, und folglich die erfindungsgemäße Schaltung einen flexiblen, vielseitigen Einsatz auch bei unterschiedlichen Umgebungsbedingungen ermöglicht.

In zweckmäßiger Weiterbildung ist vorgesehen, den Treibermodulen eine Suppressordiode nachzuschalten, vorzugsweise parallel zu der wenigstens einen anschließbaren Last.

In diesem Fall führt der Ausfall der Suppressordiode zum Kurzschluss, welches jedoch erfindungsgemäß zum Kurzschließen des Ausgangs führt und, da der Ausfall somit in eine sichere Richtung führt, für die Anwendung, insbesondere im Bereich der Sicherheitstechnik, eine vorteilhafte Weiterbildung darstellt. Sind in der Last schon Schutzbauelemente vorhanden, entfalten sie die volle Wirkung und entlasten zusätzlich die Suppressordiode.

Da ferner während des Abschaltvorgangs kein Strom über die Versorgungsquelle fließt, wird in der erfindungsgemäßen Schaltung gegebenenfalls nur eine in der Last abgespeicherte Energie umgesetzt. Hierdurch ergibt sich eine relativ kleine Belastung der Schutzelemente, also insbesondere der Suppressordiode, so dass die Schaltung insgesamt wesentlich preisgünstiger als nach dem Stand der Technik realisierbar ist.

Da bei bevorzugter Verwendung der Suppressordiode im Wesentlichen jegliche Abschaltenergie direkt am Ausgang und nicht in den Treibermodulen umgesetzt wird, ist darüber hinaus die zulässige Schaltfrequenz wesentlich höher, welches wiederum für einen Einsatz der erfindungsgemäßen Schaltung für Anwendungen von Vorteil ist, bei denen die Ausgangsspannung durch Impuls-Pausen-Verhältnis geregelt wird, wie es beispielsweise bei Analogausgangsschaltungen der Fall ist.

Da die Erfindung somit zu verkürzten Abfallzeiten der Kontakte einer Last führt, ist auch die Lebensdauer einer solchen Last, wie beispielsweise eines Relais, Schützes oder Motors, wesentlich länger als bei Schaltungen gemäß Stand der Technik. Ein weiterer Vorteil ist, dass durch das schnellere Abschalten der Last wesentlich verbesserte Reaktionszeiten erreicht werden, welches ebenfalls, insbesondere für die Anwendung in der Sicherheitstechnik, besonders vorteilhaft ist.

Da die erfindungsgemäße Schaltung somit insgesamt für weniger abzufangende Energie ausgelegt werden muss, verringern sich folglich die mit der Schaltung verbundenen Kosten. Darüber hinaus erhöhen sich die EMV (elektromagnetischen Verträglichkeits)-Eigenschaften.

Zur weiteren Reduzierung von Bauteilkomponenten und des Verdrahtungsaufwandes, ist gemäß einer weiteren praktischen Ausführungsform eine gemeinsame Rückleseschaltung für beide Ausgangstreiber vorgesehen, die wiederum vorzugsweise parallel zum Peripherieanschluss und also parallel zu der wenigstens einen anschließbaren Last angeordnet ist. Ferner ist durch die bevorzugte Anordnung der gegebenenfalls applikationsspezifisch weiter konfigurierbaren Rückleseschaltung diese für unterschiedliche Testverfahren einsetzbar.

Insbesondere können durch eine solche gemeinsame Rückleseschaltung auf einfache Weise beide Ausgangstreiber individuell auf deren Funktionsfähigkeit hin geprüft werden, wobei ein diesbezüglicher Test- oder Prüfvorgang im gesetzten oder nicht gesetzten Zustand der Treiber durch kurzzeitiges Anschalten und Ausschalten der Treibermodule jeweils nacheinander und durch Detektierung der jeweiligen Ausgangsspannung erfolgt. Werden die Ausgangstreiber im nicht gesetzten Zustand getestet, kann die Testimpulsfolge ferner so gewählt werden, dass eine Anzeige der jeweiligen Testimpulsen am Ausgang unterbunden wird, welches für den Einsatz in der Sicherheitstechnik besonders vorteilhaft ist, da die erfindungsgemäße Schaltung somit durch gezieltes Ansteuern der Treibermodule zu 100 % getestet werden kann, ohne einen unerwünschten Einfluss auf angeschaltete Lasten befürchten zu müssen. Hierbei werden bevorzugt jeweilige LOW-Zustände erfasst.

Gemäß einer weiteren bevorzugten Ausführungsform der erfindungsgemäßen Schaltung im Falle eines Einsatzes bei redundanten Lasten oder Aktoren ist jedem der Treibermodule eine ausgangsseitige Last bzw. ein ausgangsseitiger Lastkanal zugewiesen, wobei die Lasten bzw. Lastkanäle parallel zueinander an den Peripherieanschluss angeschaltet sind.

In zweckmäßiger Weise ist jedes der Treibermodule mit der Logik galvanisch getrennt verbunden, wobei die galvanische Trennung insbesondere mittels Optokoppler erfolgt. Hierdurch kann z.B. jeglicher Fehlerausschluss gegen Kurzschluss zwischen den unterschiedlichen Spannungsbereichen im voraus sichergestellt werden. Die separaten Steuerkanäle mit jeweils zwischen den Treibermodulen und der Logik galvanisch getrennten Bereichen stellen somit insbesondere sicher, dass eine Überspannung in einem Kanalbereich keine Auswirkung auf einen anderen Kanalbereich hat.

Vorzugsweise ist ferner zwischen einem Optokoppler und dem entsprechend anzusteuernden Treibermodul ein Spannungsteiler angeschaltet.

In weiterer zweckmäßiger Ausgestaltung ist ferner vorgesehen, den Aufbau der Schaltung auf diskreten Bauteilen basierend zu realisieren. Auch die Integrierung zumindest der Treibermodule innerhalb eines gemeinsamen Bauteils und ggf. die weitere Integrierung der Suppressordiode innerhalb des gemeinsamen Bauteils ist von Vorteil, da eine gemeinsame Ladungspumpe, Übertemperatur- und Überstromüberwachung verwendet werden kann und ein gemeinsames Bauteil einen geringeren Platzbedarf erfordert und kostengünstiger auszulegen ist.

Die erfindungsgemäße Schaltung ist somit bevorzugt zum Schalten eines Aktor-Schutzschaltelements verwendbar und/oder innerhalb einer Ausgangsbaugruppe integriert, welche Teil eines Masters, einer sicheren Steuerung und/oder einer Feldeinheit ist.

Die Erfindung wird nachfolgend anhand einer bevorzugten Ausführungsform unter Bezugnahme auf die beigefügten Zeichnungen näher beschrieben. In den Zeichnungen zeigen:

Fig. 1    einen Aufbau einer erfindungsgemäßen Ausgangsschaltung,

Fig. 2    die Schaltung nach Fig. 1 mit am einkanaligen Peripherieanschluss parallel angeschalteten Lasten, und

Fig. 3    eine Ausgangsschaltung nach dem Stand der Technik.

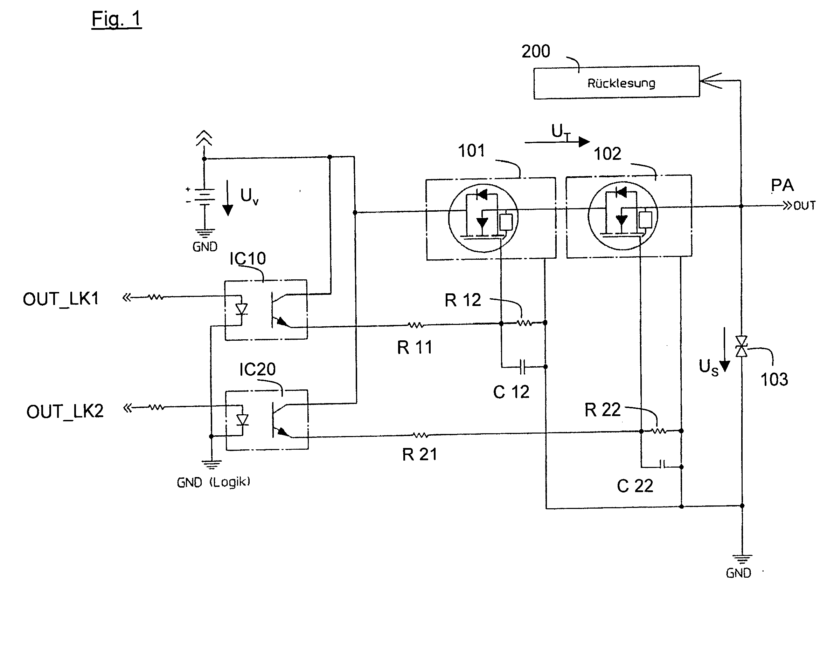

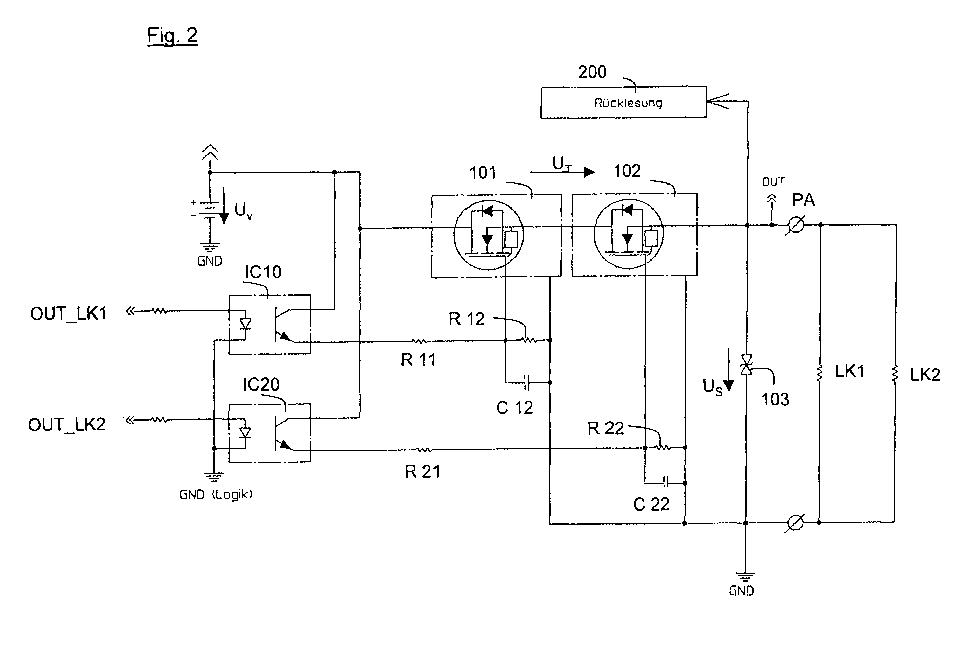

Nachfolgend wird auf die Figuren 1 und 2 Bezug genommen, welche eine erfindungsgemäße Ausgangsschaltung mit einkanaligem Peripherieanschluss "PA" für eine

*Ausgangsbaugruppe zum Schalten wenigstens einer an den Peripherieanschluss, welcher z.B. in Art einer Klemme ausgebildet ist, anzuschließenden Last, z.B. einer induktiven Last unter Einsatz diskreter Bauteile zeigen.

Die Schaltung umfasst bei der dargestellten Ausführungsform zwei Ausgangstreiber 101 und 102, die in Reihe zwischen dem gemeinsamen Peripherieanschluss PA und der Versorgungsspannung $U_V$ geschaltet sind. Die Ausgangstreiber sind im vorliegenden Fall auf FET-Transistoren aufgebaut. Sollen mehrkanalige Lasten oder Aktoren bzw. redundante Last oder Aktoren angeschlossen bzw. eingesetzt werden, sind die entsprechenden Lastkanäle LK1 und LK2, wie bei Fig. 2 zu sehen, parallel zueinander an den Peripherieanschluss PA der Ausgangsschaltung angeschaltet.

Die Ausgangstreiber 101 und 102 sind jeweils über einen separaten Steuerkanal OUT_LK1 bzw. OUT_LK2 mit einer der Ausgangsbaugruppe zugeordneten Logik zur Ansteuerung der Ausgangstreiber verbunden. Die Verbindung zwischen der nicht dargestellten Logik und den jeweils zugeordneten Ausgangstreibern 101 bzw. 102 erfolgt jeweils über einen zwischengeschalteten Optokoppler IC10 bzw. IC20, so dass der Logikbereich und der Peripheriebereich voneinander galvanisch getrennt sind. Zur Bereitstellung einer jeweiligen Treibereingangsspannung ist der Emitter-Anschluss des Optokopplers IC10 oder IC20 unter Einsatz einer applikationsspezifisch geeignet dimensionierten Schaltung mit dem Gate-Anschluss des Ausgangstreibers 101 bzw. 102 verbunden. Beim vorliegenden Beispiel umfasst die Schaltung jeweils einen aus zwei Widerständen R11 und R12 bzw. R21 und R22 aufgebauten Spannungsteiler und einen parallel zum Widerstand R12 oder R22 geschalteten und gleichfalls mit Masse verbundenen Kondensator C12 bzw. C22. Die zwischen Gate-Anschluss und Masse geschalteten Kondensatoren C12 und C22 dienen hierbei insbesondere einer verbesserten EMV.

Durch die somit getrennten Ansteuerwege und die mittels der zwei Ausgangstreiber 101 und 102 bereitgehaltenen Abschaltwege, ist somit beim dargestellten Ausführungsbeispiel das Anschalten sowohl von einkanaligen als auch von zweikanaligen Aktoren an dem einkanaligen Peripherieanschluss PA auch unter Einhaltung der Sicheranforderungen nach Kat. 4 DIN EN 954 und SIL 3 IEC 61508 ermöglicht.

Zum Schutz gegen Überspannung und insbesondere gegen induktive Abschaltenergie im Falle von induktiven Lasten, ist mit dem Ausgang ferner eine Suppressordiode 103 mit einer maximalen Spannung von beispielsweise 35 Volt verbunden. Die Suppressordiode 103 ist parallel zur anschaltbaren Last geschaltet und schützt die erfindungsgemäße Ausgangsschaltung zusätzlich gegen EMV-Störungen.

Es sei darauf hingewiesen, dass die Ausgangstreibern 101 und 102 und weitere Komponenten, z.B. die Suppressordiode 103, auch innerhalb eines gemeinsamen Bauteils integriert sein können.

Im Falle induktiver Lasten wird die induktive Abschaltenergie somit im Wesentlichen lediglich intern in der Suppressordiode 103 umgesetzt. Aufgrund der mit den in Reihe geschalteten Ausgangstreibern 101 und 102 realisierten Ausgangsschaltung wird beim Abschalten einer oder zweier induktiven Lasten keine Energie in den Ausgangstreibern 101 und 102 umgesetzt. Da die Ausgangstreiber 101 und 102 in Reihe geschaltet sind und im Normalbetrieb zweckmäßigerweise beide gleichzeitig ein- und ausgeschaltet werden, setzt sich die maximale Abschaltspannung über beide Ausgangstreiber 101 und 102 beim Abschalten einer induktiven Last wie folgt zusammen. Am Ausgang bzw. am Peripherieanschluss ist eine Last L angeschaltet.

Beträgt die maximale Versorgungsspannung $U_V$ = 30 Volt und die Klemmspannung $U_S$ der Suppressordiode 103 35 Volt, verhält sich die maximale zulässige Spannung $U_T$ über beide Ausgangstreiber wie folgt:

$$U_T > U_V + U_S = 65 \text{ Volt.} \qquad (1)$$

Aufgrund der Reihenschaltung teilt sich jedoch die maximale Spannung über beide Ausgangstreiber 101 und 102 von 65 Volt hälftig auf und belastet somit jeden der Ausgangstreiber mit etwa 33 Volt. Die Spannung der parasitären Zehner-Diode eines jeden Ausgangstreibers 101 bzw. 102 beträgt jedoch typischerweise 45 Volt, so dass diese Zehner-Dioden der Ausgangstreiber nicht leitend werden.

Ferner umfasst die erfindungsgemäße Schaltung eine gemeinsame, den Ausgangstreibern 101 und 102 nachgeschaltete Rückleseeinrichtung 200, welche bevorzugt parallel zur anschaltbaren Last angeordnet ist. Insbesondere zum Testen der Ausgangstreiber 101 und 102 ist somit nur eine gemeinsame Rückleseeinrichtung 200 erforderlich, wobei die Ausgangstreiber 101 und/oder 102 hierzu nacheinander kurzzeitig angeschaltet und/oder ausgeschaltet werden und der jeweilige Zustand der Ausgangsspannungen über die Rückleseschaltung 200 zurück gelesen wird, wie nachfolgend näher beschrieben. Dadurch kann eine Diagnose mit hundertprozentiger Fehleraufdeckung der Schaltung realisiert werden. Je nach applikationsspezifischen Schaltungsaufbau ist die Rückleseeinrichtung 200 ferner zum Testen einer Vielzahl von weiteren Bauteilen einsetzbar.

Basierend auf der vorstehend beschriebenen Ausbildung der erfindungsgemäßen Ausgangsschaltung werden nachfolgend drei bevorzugte Verfahren zum Testen der Ausgangstreiber 101 und 102 beschrieben, wobei mit Hilfe der Rückleseeinrichtung 200 der Zustand des Ausgangs am Peripherianschlusses PA erfasst und mit einem Soll-Zustand verglichen wird.

Bei einem ersten Verfahren, bei welchem Testimpulse am Ausgang sichtbar sind bzw. anliegen, erfolgt der Test im gesetzten Zustand, d.h. im "High-Zustand" der Ausgangstreiber 101 und 102. Im gesetzten Zustand werden die Ausgangstreiber 101 und 102 hierbei mittels Abschaltimpulsen getestet, wobei zweckmäßigerweise eine maximale Breite des Testimpulses vorgegeben wird. Pro Testimpuls wird von den zwei in Reihe geschalteten Treibern 101 und 102 immer nur einer, also der Ausgangstreiber 101 oder 102, getestet. Dieser Testimpuls ist an dem Ausgang sichtbar und wird durch die Rückleseschaltung 200 erfasst. Sofern solche Testimpulse je nach angeschalteter Last auf diese störend wirken sollten, kann diesem z.B. durch Pufferkondensatoren und zusätzliche Entkopplungsdioden entgegengewirkt werden. Eine beispielhafte Testreihenfolge dieses ersten Verfahrens umfasst folgende Schritte:

Zunächst sind beide Ausgangstreiber 101 und 102 im gesetzten Zustand. Anschließend wird einer der Ausgangstreiber zurückgesetzt und der "Low-Zustand" am Ausgang wird durch die Rückleseschaltung 200 erfasst. Anschließend wird dieser Ausgangstreiber wieder gesetzt und der "High-Zustand" wird durch die Rückleseschaltung 200 erfasst. Testimpulse sind wiederum am Ausgang sichtbar. Anschließend wird der andere Ausgangstreiber zurückgesetzt und der "Low-Zustand" am Ausgang wird durch die Rückleseschaltung 200 erfasst. Daraufhin wird dieser andere Ausgangstreiber wieder gesetzt und der "High-Zustand" wird durch die Rückleseschaltung erfasst. Da die Testimpulse nur von kurzer Dauer sind, ist hier die thermische Belastung der Ausgangstreiber vernachlässigbar.

Weitere Möglichkeiten bestehen darin, die Schaltung im nicht gesetzten Zustand zu testen.

Bei einer ersten Variante, die Schaltung im nicht gesetzten ("LOW-Zustand") zu testen, werden die Ausgangstreiber im nicht gesetzten Zustand mittels Einschaltimpulsen getestet. Damit hierbei eine angeschlossene Last nicht durchschalten kann, muss bei diesen Tests die jeweilige Einschaltdauer, d.h. der Einschaltimpuls, so klein wie möglich gehalten werden. Eine beispielhafte Testreihenfolge dieser ersten Variante umfasst folgende Schritte:

Zunächst sind beide Ausgangstreiber 101 und 102 im nicht gesetzten Zustand. Anschließend werden beide Ausgangstreiber gesetzt und der "High-Zustand" der Schaltung am Ausgang wird durch die Rückleseschaltung 200 erfasst. Anschließend wird ein erster Treiber zurückgesetzt und der "Low-Zustand" der Schaltung wird durch die Rückleseschaltung 200 erfasst. Daraufhin wird dieser erste Ausgangstreiber wieder gesetzt und der "High-Zustand" am Ausgang wird durch die Rückleseschaltung 200 erfasst. Anschließend wird der zweite Ausgangstreiber zurückgesetzt und der "Low-Zustand" der Schaltung am Ausgang wird durch die Rückleseschaltung 200 erfasst. Daraufhin wird auch der erste Ausgangstreiber wieder zurückgesetzt.

Bei einer weiteren Variante, die Schaltung im nicht gesetzten ("LOW-Zustand") zu testen, werden die Ausgangstreiber im nicht gesetzten Zustand durch Änderung der Testreihenfolge derart getestet, dass die Testimpulse am Ausgang unterbunden werden. Da in Folge der somit am Ausgang nicht sichtbaren Testimpulse auch eine angeschlossene Last in keiner Weise störend durch die Testimpulse beeinflusst wird, ist eine solche Variante eine besonders bevorzugte. Eine beispielhafte Testreihenfolge einer solchen zweiten Variante umfasst folgende Schritte:

Zunächst sind beide Ausgangstreiber 101 und 102 im nicht gesetzten Zustand. Anschließend wird ein erster Ausgangstreiber gesetzt und der "Low-Zustand" am Ausgang wird durch die Rückleseschaltung 200 erfasst. Daraufhin wird dieser erste Treiber wieder zurückgesetzt und der "Low-Zustand" wird durch die Rückleseschaltung 200 erfasst. Daraufhin wird der zweite Ausgangstreiber gesetzt und der "Low-Zustand" am Ausgang wird durch die Rückleseschaltung 200 erfasst. Anschließend wird dieser zweite Treiber wieder zurückgesetzt und der "Low-Zustand" wird durch die Rückleseschaltung 200 erfasst.

Auch dieser Test reicht für Kategorie 4 nach DIN EN 954 bzw. SIL 3 nach DIN EN 61508 aus, wenn ein jeweiliger Ausgangstreiber über ein geeignetes Zeitintervall eingeschaltet bleibt ohne, dass ein Zustandswechsel erfasst wird, so dass ein Defekt des jeweils anderen Ausgangstreibers ausgeschlossen werden kann.

Die erfindungsgemäße Schaltung eignet somit bevorzugt zum Schalten von sicherheitsrelevanten Aktor-Schutzschaltelementen, z.B. in Form von Relais, Schützen oder Motoren und/oder ist innerhalb einer nicht näher dargestellten Ausgangsbaugruppe, insbesondere einer Bus-Ausgangsbaugruppe, integriert, welche bevorzugt Teil eines Masters, einer sicheren Steuerung und/oder einer Feldeinheit ist.

## Patentansprüche

1. Ausgangsschaltung für eine Ausgangsbaugruppe zum Schalten wenigstens einer angeschlossenen Last, insbesondere induktiven Last,
   **gekennzeichnet durch**
   einen einkanaligen Peripherieanschluss (PA) zum Anschließen der wenigstens einen Last, wenigstens zwei zwischen einer Versorgungsspannung und dem Peripherieanschluss in Reihe geschaltete Treibermodule (101; 102), insbesondere FET-Transistoren, wobei jedes der Treibermodule über einen separaten Steuerkanal (OUT_LK1, IC10; OUT_LK2, IC20) mit einer der Ausgangsbaugruppe zugeordneten Logik zur Ansteuerung der Treibermodule verbunden ist.

2. Ausgangsschaltung nach vorstehendem Anspruch, ferner **gekennzeichnet durch** eine Suppressordiode (103), welche den Treibermodulen nachgeschaltet ist.

3. Ausgangsschaltung nach vorstehendem Anspruch, **dadurch gekennzeichnet, dass** die Suppressordiode parallel zum Peripherieanschluss geschaltet ist.

4. Ausgangsschaltung nach einem der vorstehenden Ansprüche, ferner **gekennzeichnet durch** eine gemeinsame Rückleseschaltung (200).

5. Ausgangsschaltung nach vorstehendem Anspruch, ferner **dadurch gekennzeichnet, dass** die gemeinsame Rückleseschaltung parallel zum Peripherieanschluss angeordnet ist.

6. Ausgangsschaltung nach einem der vorstehenden Ansprüche, **dadurch gekennzeichnet, dass** jedem der Treibermodule eine ausgangsseitige Last zuweisbar ist, wobei die Lasten parallel zueinander an den Peripherieanschluss anschaltbar sind.

7. Ausgangsschaltung nach einem der vorstehenden Ansprüche, **dadurch gekennzeichnet, dass** jedes der Treibermodule mit der Logik galvanisch getrennt, insbesondere über einen Optokoppler (IC10; IC20), verbunden ist.

8. Ausgangsschaltung nach vorstehendem Anspruch, ferner **dadurch gekennzeichnet, dass** jeweils zwischen einem Optokoppler und einem Treibermodul ein Spannungsteiler (R11, R12; R21, R22) angeschaltet ist.

9. Ausgangsschaltung nach einem der vorstehenden Ansprüche, ferner **gekennzeichnet durch** einen Aufbau basierend auf diskreten Bauteilen.

10. Ausgangsschaltung nach einem der vorstehenden Ansprüche, ferner **gekennzeichnet durch** die Integrierung der Treibermodule innerhalb eines gemeinsamen Bauteils.

11. Ausgangsschaltung nach vorstehendem Anspruch, ferner **gekennzeichnet durch** die Integrierung einer Suppressordiode innerhalb des gemeinsamen Bauteils.

12. Ausgangsschaltung nach einem der vorstehenden Ansprüche, wobei die Ausgangsbaugruppe eine Bus-Ausgangsbaugruppe ist.

13. Ausgangsbaugruppe umfassend eine Ausgangsschaltung nach einem der vorstehenden Ansprüche.

14. Ausgangsbaugruppe nach vorstehendem Anspruch, welche Teil eines Masters, einer sicheren Steuerung und/oder einer Feldeinheit ist.

15. Ausgangsbaugruppe nach einem der beiden vorstehenden Anpspüche, welche eine Bus-Ausgangsbaugruppe ist.

16. Verwendung einer Ausgangsschaltung nach einem der vorstehenden Ansprüche zum Schalten einer Ausgangsspannung in Abhängigkeit eines bestimmten Impuls-Pausen-Verhältnisses.

17. Verwendung einer Ausgangsschaltung nach vorstehendem Anspruch innerhalb einer Analogausgangsschaltung.

18. Verwendung einer Ausgangsschaltung nach einem der vorstehenden Ansprüche in der Sicherheitstechnik.

19. Verwendung einer Ausgangsschaltung nach einem der vorstehenden Ansprüche zum Treiben eines Aktorschutzschaltelements, z.B. eines Relais, Schützes oder Motors.

20. Verfahren zum Testen einer Schaltung nach einem der vorstehenden Ansprüche, **dadurch gekennzeichnet, dass** im gesetzten oder nicht gesetzten Zustand der Treibermodule getestet wird, wobei jedes der Treibermodule kurz nacheinander ausgeschaltet bzw. angeschaltet wird und die jeweilige Ausgangsspannung detektiert wird.

21. Verfahren zum Testen einer Schaltung nach einem der vorstehenden Ansprüche 1 bis 19, **dadurch gekennzeichnet**, im nicht gesetzten Zustand der Treibermodule getestet wird, wobei die Treibermodule in einer Testreihenfolge angeschaltet und ausgeschaltet werden, dass eine Anzeige von jeweils verwendeten Testimpulsen am Ausgang unterbunden wird.

22. Verfahren nach Anspruch 21, **dadurch gekennzeichnet, dass** Testimpulse jeweils zum Erfassen von LOW-Zuständen der Schaltung generiert werden.

Fig. 1

EP 1 873 916 A2

Fig. 2

EP 1 873 916 A2

Fig. 3